# EUROPEAN PATENT APPLICATION

(11) **EP 4 704 128 A1**
(43) Date of publication of application: **04.03.2026**
(21) Application number: 24795989.3
(22) Date of filing: 22.04.2024
(51) Int. Cl.: H01H 13/14, H01H 13/28, H05K 5/02

(54) **ELECTRONIC DEVICE**

(30) Priority: 28.04.2023 CN 202310474341
(71) Applicant: Vivo Mobile Communication Co., Ltd., Dongguan, Guangdong 523863 (CN)
(72) Inventor: ZHENG, Zongmao, Dongguan, Guangdong 523863 (CN); FENG, Zhixin, Dongguan, Guangdong 523863 (CN)
(74) Representative: Conti, Marco
(86) International application number: PCT/CN2024/089029
(87) International publication number: WO 2024/222608

(57) **Abstract**

Embodiments of this application provide an electronic device, including a frame body and a button assembly, where the frame body includes a first side surface and a second side surface, the second side surface is exposed to an outer surface of the electronic device, a mounting groove is provided in the frame body, a first opening is provided on the first side surface, a second opening is provided on the second side surface, and both the first opening and the second opening are in communication with the mounting groove; the button assembly includes a button cap and an elastic member, the button cap is disposed in the second opening, the elastic member is disposed in the mounting groove, a slide cover is disposed in the first opening, and the slide cover is detachably connected to the frame body; and a projection size of the elastic member on the first side surface is smaller than a size of the first opening, and a projection size of the elastic member on the second side surface is larger than a size of the second opening.

## Description

### CROSS-REFERENCE TO RELATED APPLICATIONS

This application claims priority to Chinese Patent Application No. 202310474341.1, entitled "ELECTRONIC DEVICE" filed with the China National Intellectual Property Administration on April 28, 2023, which is incorporated herein by reference in its entirety.

### TECHNICAL FIELD

This application relates to the field of electronic product technologies, and in particular, to an electronic device.

### BACKGROUND

In the related art, a button is disposed on an electronic device for implementing different functions of the electronic device, for example, a power button for turning on/off the device, a mute button for one-click mute, or a volume button for adjusting volume. To adapt to a full-screen development trend of the electronic device, the button is usually disposed on a side of the electronic device.

However, as the electronic device becomes light and thin, a size of the button disposed on the side in a thickness direction is continuously reduced. However, reducing the size of the button in the thickness direction causes pressing instability of the button, resulting in button failure after the button is pressed for a plurality of times. It can be seen that there is a problem in the related art that a trend of the electronic device becoming light and thin and stability of a side button cannot be both achieved.

### SUMMARY

Embodiments of this application provide an electronic device, to implement a design for the electronic device to become light and thin while stability of a side button is ensured.

According to a first aspect, an embodiment of this application provides an electronic device, including a frame body and a button assembly, where
the frame body includes a first side surface and a second side surface, the second side surface is exposed to an outer surface of the electronic device, a mounting groove is provided in the frame body, a first opening is provided on the first side surface, a second opening is provided on the second side surface, and both the first opening and the second opening are in communication with the mounting groove;
the button assembly includes a button cap and an elastic member, the button cap is disposed in the second opening, the elastic member is disposed in the mounting groove, a slide cover is disposed in the first opening, and the slide cover is detachably connected to the frame body; and
a projection size of the elastic member on the first side surface is smaller than a size of the first opening, and a projection size of the elastic member on the second side surface is larger than a size of the second opening.

In this embodiment of this application, the first opening is provided on the first side surface of the frame body, the slide cover is disposed in the first opening, and the second opening is provided on the second side surface of the frame body. In addition, the projection size of the elastic member on the first side surface is smaller than the size of the first opening, and the projection size of the elastic member on the second side surface is larger than the size of the second opening, so that the elastic member can be directly mounted in the mounting groove from the first opening. In this way, when the size of the second opening is reduced, a size of the elastic member does not need to be reduced. Therefore, in this embodiment of this application, the design for the electronic device to become light and thin can be implemented while the stability of the side button is ensured.

Additional aspects and advantages of this application are partially provided in the following descriptions, and partially become apparent in the following descriptions or are learned through practice of this application.

### BRIEF DESCRIPTION OF THE DRAWINGS

The foregoing and/or additional aspects and advantages of this application become apparent and comprehensible in descriptions of embodiments made with reference to the following accompanying drawings.
FIG. 1 is a schematic diagram of an exploded structure of a button assembly in a conventional electronic device;
FIG. 2 is a schematic diagram of an exploded structure of a button assembly in an electronic device according to an embodiment of this application;
FIG. 3 is a schematic structural diagram of a slide cover in an electronic device from a perspective according to an embodiment of this application;
FIG. 4 is a schematic diagram of a partial structure of a frame body in an electronic device according to an embodiment of this application;
FIG. 5 is a schematic structural diagram of a slide cover in an electronic device from another perspective according to an embodiment of this application; and
FIG. 6 to FIG. 13 are schematic diagrams of an assembled structure of a button assembly in an electronic device according to an embodiment of this application.

### DETAILED DESCRIPTION

Embodiments of this application are described in detail below, and examples of the embodiments are shown in the accompanying drawings, where the same or similar elements or the elements having same or similar functions are denoted by the same or similar reference numerals throughout the specification. The embodiments described below with reference to the accompanying drawings are exemplary and are only used to explain this application, and cannot be understood as a limitation on this application. Based on the embodiments of this application, all other embodiments obtained by a person of ordinary skill in the art without creative efforts shall fall within the protection scope of this application.

Features of terms "first" and "second" in the specification and claims of this application may explicitly or implicitly include one or more of the features. In the descriptions of the present invention, unless otherwise stated, "a plurality of" means two or more than two. In addition, "and/or" in the specification and the claims represents at least one of the connected objects, and the character "/" usually represents an "or" relationship between the associated objects.

In the descriptions of the present invention, it is to be understood that an orientation relationship or a position relationship indicated by terms such as "center", "longitudinal", "transverse", "length", "width", "thickness", "upper", "lower", "front", "rear", "left", "right", "vertical", "horizontal", "top", "bottom", "inner", "outer", "clockwise", "anticlockwise", "axial direction", "radial direction", and "circumferential direction" are based on an orientation relationship or a position relationship shown in the accompanying drawings, are merely used to facilitate the descriptions of the present invention and simplify the descriptions, but are not used to indicate or imply that the indicated apparatus or element needs to have a particular orientation or be constructed and operated in a particular orientation, and therefore, cannot be understood as a limitation on the present invention.

In the descriptions of the present invention, it should be noted that, unless otherwise explicitly specified or defined, the terms such as "mount", "connect", and "connection" should be understood in a broad sense. For example, the connection may be a fixed connection, a detachable connection, or an integral connection; the connection may be a mechanical connection or an electrical connection; or the connection may be a direct connection, an indirect connection through an intermediate medium, or internal communication between two elements. A person of ordinary skill in the art may understand specific meanings of the foregoing terms in the present invention based on a specific situation.

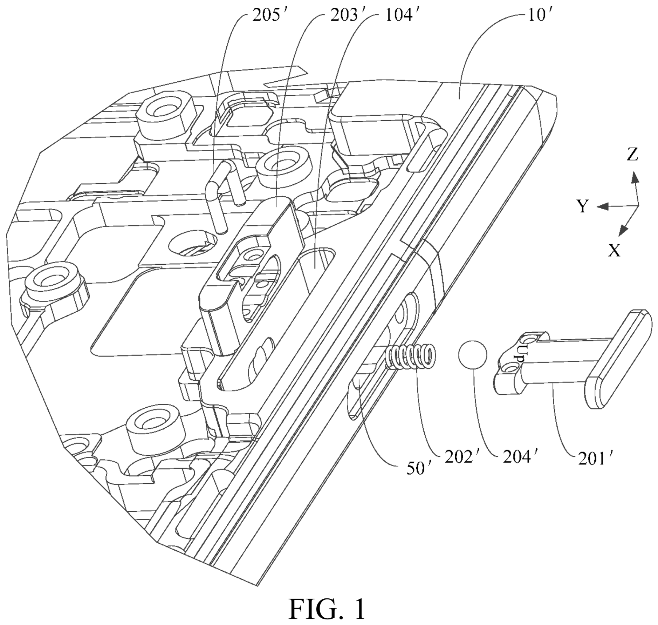

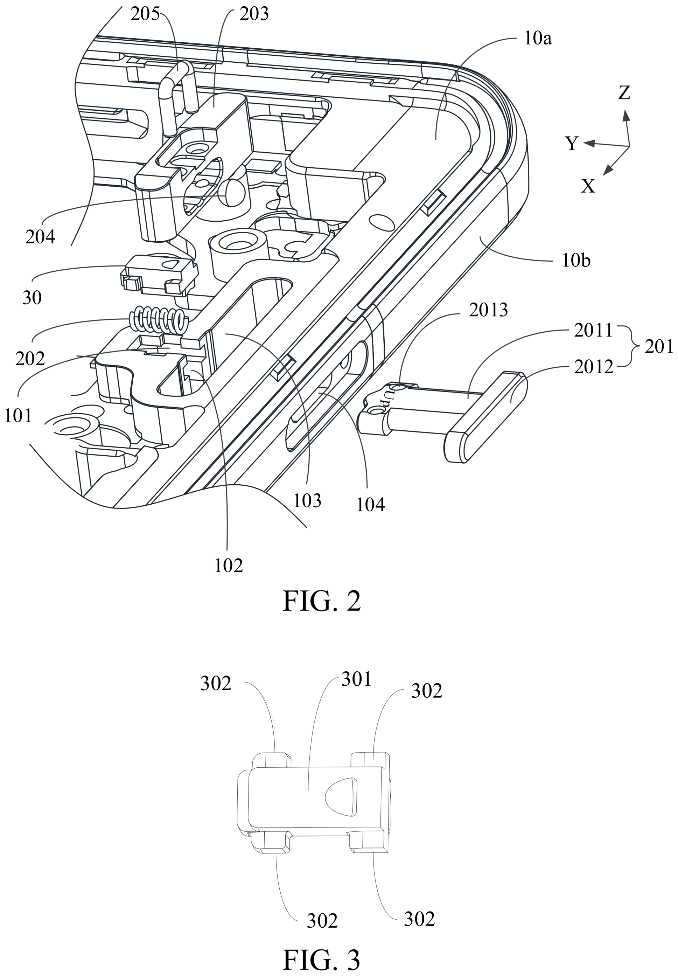

To better describe this application, a coordinate system shown in FIG. 1 and FIG. 2 is established. A Z-axis represents a thickness direction of a frame body, an X-axis may represent a length direction (or a width direction) of the frame body, and a Y-axis represents a width direction (or a length direction) of the frame body.

In this embodiment of this application, an electronic device may be a foldable-screen electronic device. The foldable-screen electronic device includes a first housing portion and a second housing portion. The first housing portion may be understood as a housing portion carrying a sub-screen, and the second housing portion may be understood as a housing portion carrying a main screen. Currently, an overall thickness of a first-generation foldable-screen electronic device is large, and design of a mute button structure of a side surface of a first housing is not excessively limited. The mute button structure is shown in FIG. 1. The mute button structure mainly includes: a frame body 10', a button cap 201', an elastic member 202', a limiting member 203', and a rotating member 204'. A third opening 104' adapted to the limiting member 203' is provided on a first side surface of the frame body 10', and a blind hole 50' is provided on a second side surface of the frame body 10'. The blind hole 50' is in communication with the third opening 104'.

Optionally, during assembly, the elastic member 202' is first directly inserted into a bottom of the blind hole 50'. Then, the limiting member 203' is mounted, so that a limiting through groove 2031' of the limiting member 203' is aligned with the blind hole 50', and then a steel ball is inserted from the blind hole 50', and is located between the limiting member 203' and the elastic member 202' through the limiting through groove 2031'. Next, the button cap 201' is inserted into the blind hole 50'. Finally, the limiting member 203' is fixed to the button cap 201' by using a pin 205'. Optionally, the rotating member 204' is a steel ball made of a stainless steel material.

To implement a light and thin electronic device in a second-generation foldable-screen electronic device, a size of the button cap 201' needs to be reduced. However, to ensure stability of a side button, a size of the elastic member 202' needs to be ensured to be unchanged. Therefore, the electronic device according to this application is provided.

Refer to FIG. 2. An embodiment of this application provides an electronic device. As shown in FIG. 2 to FIG. 10, the electronic device in this embodiment of this application includes: a frame body 10 and a button assembly, where
the frame body 10 includes a first side surface 10a and a second side surface 10b, the second side surface 10b is exposed to an outer surface of the electronic device, a mounting groove 101 is provided in the frame body 10, a first opening 102 is provided on the first side surface 10a, a second opening 103 is provided on the second side surface 10b, and both the first opening 102 and the second opening 103 are in communication with the mounting groove 101;
the button assembly includes a button cap 201 and an elastic member 202, the button cap 201 is disposed in the second opening 103, the elastic member 202 is disposed in the mounting groove 101, a slide cover 30 is disposed in the first opening 102, and the slide cover 30 is detachably connected to the frame body 10; and
a projection size of the elastic member 202 on the first side surface 10a is smaller than a size of the first opening 102, and a projection size of the elastic member on the second side surface 10b is larger than a size of the second opening 103.

In this embodiment of this application, the electronic device may be a mobile terminal like a mobile phone and a tablet computer. When the electronic device is a mobile phone, the frame body 10 may be understood as a middle frame. The middle frame usually includes an outer frame and an inner frame. In this embodiment of this application, the outer frame and the inner frame are considered as a whole, that is, the frame body 10.

Optionally, the slide cover 30 may be mounted and fixed in the first opening 102 by using a drawer-type structure, or may be fixed in a manner like snapping or threading. The button cap 201 usually includes a connecting portion 2011 and a pressing portion 2012. A part of the pressing portion 2012 is exposed to an outside of the frame body 10, thereby helping a user to apply a pressing force. Sizes of radial sections of the connecting portion 2011 and the pressing portion 2012 in the second opening 103 may be the same or may be different.

It should be noted that, that a projection size of the elastic member 202 on the first side surface 10a is smaller than a size of the first opening 102 may be understood as that a diameter of a circumscribed circle corresponding to a projection of the elastic member 202 on the first side surface 10a is smaller than an aperture (or a smallest aperture) of the first opening 102, or that a projection of the elastic member 202 on the first side surface 10a is located in an opening that is formed by the first opening 102 on the first side surface 10a, that is, the elastic member 202 may be mounted in the mounting groove 101 through the first opening 102. Because the first opening 102 is provided on the first side surface 10a of the frame body 10 for the elastic member 202 to be mounted in the mounting groove 101, the size of the second opening 103 on the second side surface 10b can be reduced, so that a size of the frame body 10 can be reduced while stability of a button is ensured, thereby facilitating design of miniaturization of the electronic device.

It should be understood that, that a projection size of the elastic member 202 on the second side surface 10b is larger than a size of the second opening 103 may be understood as that a diameter of a circumscribed circle corresponding to a projection of the elastic member 202 on the second side surface 10b is less than an aperture (or a smallest aperture) of the second opening 103, or that a projection of the elastic member 202 on the second side surface 10b is located in an opening that is formed by the second opening 103 on the second side surface 10b, that is, the elastic member 202 cannot pass through the second opening 103.

In this embodiment of this application, the first opening 102 is provided on the first side surface 10a of the frame body 10, the slide cover 30 is disposed in the first opening 102, and the second opening 103 is provided on the second side surface 10b of the frame body 10. In addition, the projection size of the elastic member 202 on the first side surface 10a is smaller than the size of the first opening 102, and the projection size of the elastic member on the second side surface is larger than the size of the second opening, so that the elastic member can be directly mounted in the mounting groove from the first opening. In this way, when the size of the second opening is reduced, a size of the elastic member does not need to be reduced. Therefore, in this embodiment of this application, a design for the electronic device to become light and thin can be implemented while stability of a side button is ensured.

Optionally, in some embodiments, the slide cover 30 includes a slide cover body 301 and at least two slide bumps 302 disposed on the slide cover body 301, the slide cover body 301 and the slide bumps 302 are located in the first opening 102, and the slide bumps 302 are movable between a first position and a second position.

When the slide bumps 302 are located at the first position, the slide bumps 302 abut against an inner wall of the first opening 102; and when the slide bumps 302 are located at the second position, the slide bumps 302 are removable from the first opening 102.

In this embodiment of this application, the slide bumps 302 are movable in the first opening 102, for example, in a drawer-type slide structure. The slide cover 30 is mounted in the first opening 102 by using the drawer-type slide structure, so that the slide cover 30 can be conveniently disassembled and assembled, thereby facilitating subsequent repair.

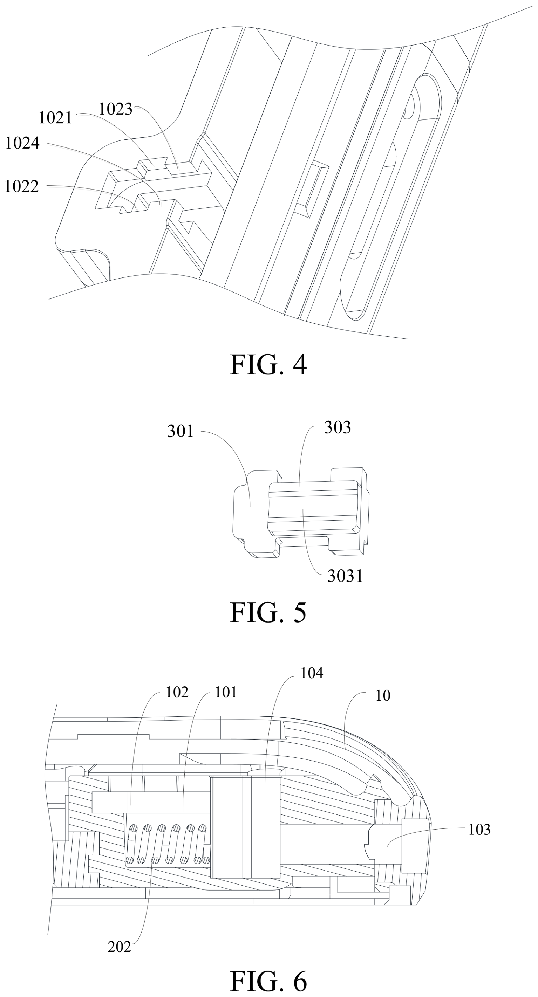

It should be noted that, a position and a quantity of the slide bumps 302 disposed can be set based on an actual requirement. For example, in some embodiments, as shown in FIG. 3 and FIG. 4, two of the slide bumps 302 are disposed at an interval on a first side of the slide cover body 301, two of the slide bumps 302 are disposed at an interval on a second side of the slide cover body 301, a first recessed portion 1021 adapted to one of the slide bumps 302 on the first side of the slide cover body 301 and a second recessed portion 1022 adapted to one of the slide bumps 302 on the second side of the slide cover body 301 are disposed in the first opening 102, a first protrusion portion 1023 is formed between the first recessed portion 1021 and a third opening 104 provided on the first side surface 10a, and the two slide bumps 302 of the first side of the first protrusion portion 1023 are adaptive; and a second protrusion portion 1024 is formed between the second recessed portion 1022 and the third opening 104, and the second protrusion portion 1024 is adapted to the two slide bumps 302 of the second side.

In this embodiment of this application, the slide bumps 302 may be disposed in parallel and at an interval along the slide cover body 301. The slide bumps 302 may be first aligned with the first recessed portion 1021, the second recessed portion 1022, and the third opening 104. Then, the slide cover body 301 is sent into the first opening 102, so that a part of the slide cover body 301 is disposed in the first opening 102, and a part of the slide cover body 301 is disposed in the third opening 104. Then, the slide cover body 301 is pushed to slide toward an inside of the first opening 102, so that the slide cover body 301 is located in the first opening 102. In this case, the slide bumps 302 respectively abut against the inner wall of the first opening 102. The slide bumps 302 close to the third opening 104 are respectively disposed corresponding to the first protrusion portion 1013 and the second protrusion portion 1014.

Because two of the slide bumps 302 are disposed at two opposite sides of the slide cover body 301, mounting stability of the slide cover body 301 in the first opening 102 can be improved. Certainly, in other embodiments, one slide bump 302 may be further disposed on each side of the slide cover body 301, so that the first recessed portion 1021 and the second recessed portion 1022 do not need to be disposed.

Optionally, as shown in FIG. 5, in some embodiments, a pressing plate 303 is disposed on a surface of the slide cover body 301 that faces the mounting groove 101, and an arc-shaped concave surface 3031 adapted to the elastic member 20 is formed on a surface of the pressing plate 303 that faces the mounting groove 101.

In this embodiment of this application, the elastic member 20 may be a spring. The arc-shaped concave surface 3031 is disposed, to better accommodate the elastic member 20 in the mounting groove 101 and enable the elastic member 20 to freely extend and retract in the mounting groove 101.

Optionally, in some embodiments, a third recessed portion 3011 is disposed on a side of the slide cover body 301 that is away from the mounting groove 101.

In this embodiment of this application, the third recessed portion 3011 is used as a force-bearing point of a tweezer during assembly or disassembly. A specific structure of the third recessed portion 3011 may be set based on an actual requirement, and is not further limited herein. Because the third recessed portion 3011 is disposed, it may be more convenient to disassemble and assemble the slide cover 30.

Optionally, in some embodiments, the elastic member 202 is a spring, a width of the second opening 103 in a first direction is less than an outer diameter of the spring, the first direction is a direction from the first side surface 10a to a third side surface of the frame body 10, and the first side surface 10a and the third side surface are disposed opposite to each other.

In this embodiment of this application, that a width of the second opening 103 in a first direction is less than an outer diameter of the spring may be understood as that a width, in the first direction, of a part of the second opening 103 that is configured to accommodate a connecting portion 601 is smaller than the outer diameter of the spring. Certainly, in some embodiments, a thickness of the button cap 201 in the first direction is substantially consistent, that is, the width of the second opening 103 in the first direction is also substantially consistent. In this case, that a width of the second opening 103 in a first direction is less than an outer diameter of the spring may be understood as a width of the second opening 103 at any position in the first direction being smaller than the outer diameter of the spring.

It should be understood that, in other embodiments, the elastic member may alternatively use another structure, for example, a structure having elastic deformation such as a metal spring.

Optionally, in some embodiments, the third opening 104 is further disposed on the first side surface 10a, the third opening 104 is separately in communication with the first opening 102 and the mounting groove, and the button assembly further includes a limiting member 203 and a rotating member 204.

The limiting member 203 is disposed in the third opening 104. The limiting member 203 is detachably and fixedly connected to the button cap 201. The limiting member 203 is provided with a limiting through groove 2031 configured to communicate with the mounting groove 101 and the second opening.

The rotating member 204 is disposed between the elastic member 202 and the limiting member 203.

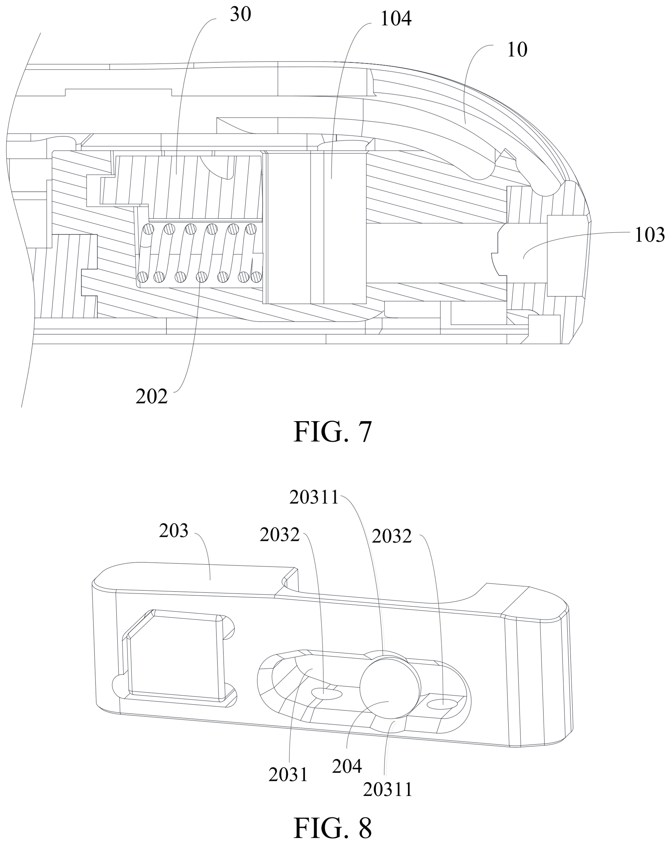

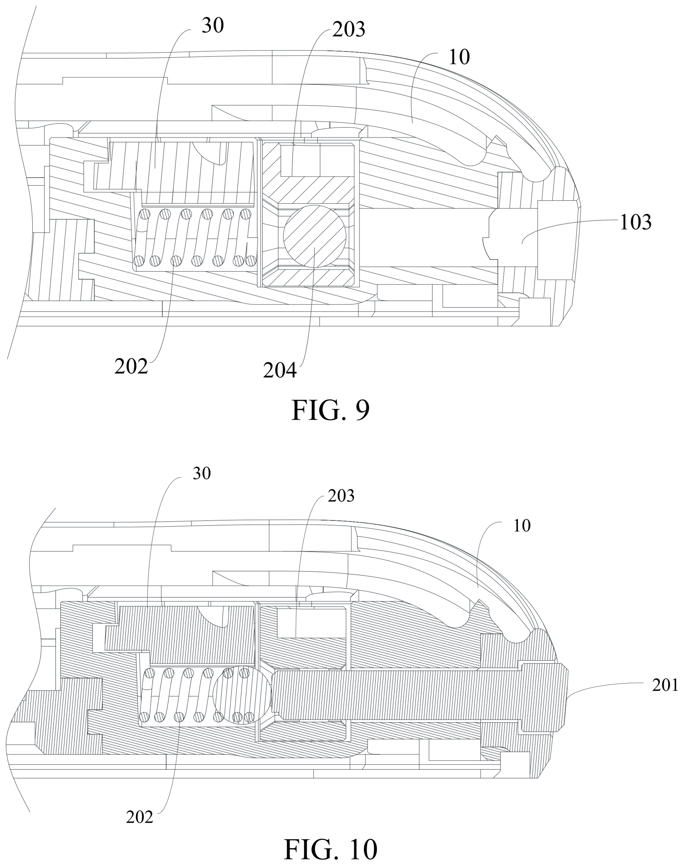

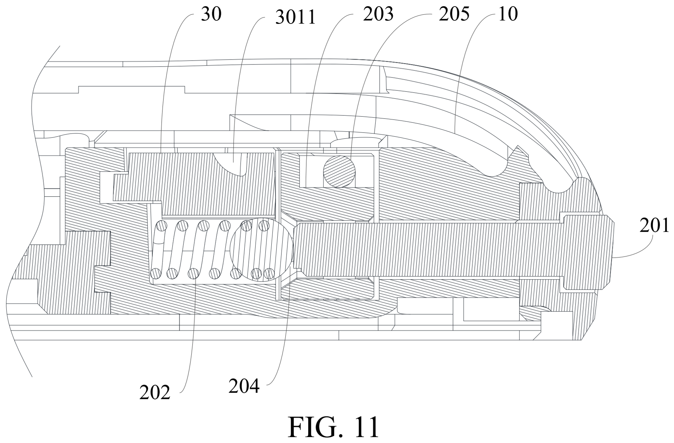

During mounting, the elastic member 202 is first located in the mounting groove 101 through the first opening 102, to form a structure shown in FIG. 6. Then, the slide cover 30 is mounted in the first opening 102, and the elastic member 202 is pressed by the slide cover 30, to form a structure shown in FIG. 7. Next, the rotating member 204 is inserted into a limiting through groove 401 of the limiting member 203. For example, the rotating member 204 is initially fixed in the limiting through groove 401 of the limiting member 203 by using colloidal oil, as specifically shown in FIG. 8. Then, the limiting member 203 is inserted into a second recessed groove, so that the limiting through groove 401 is corresponding to the second opening 103 and the mounting groove 101, to form a structure shown in FIG. 9. Then, the button cap 201 is inserted into the second opening 103, and the button cap 201 is inserted into the limiting through groove 401 through the second opening 103 to push the rotating member 204 into the mounting groove 101, to form a structure shown in FIG. 10 (certainly, in some embodiments, the rotating member 204 may be pushed into the mounting groove 101 by using another workpiece before the button cap 201 is inserted). Finally, the button cap 201 is fixed to the limiting member 203, to form a structure shown in FIG. 11.

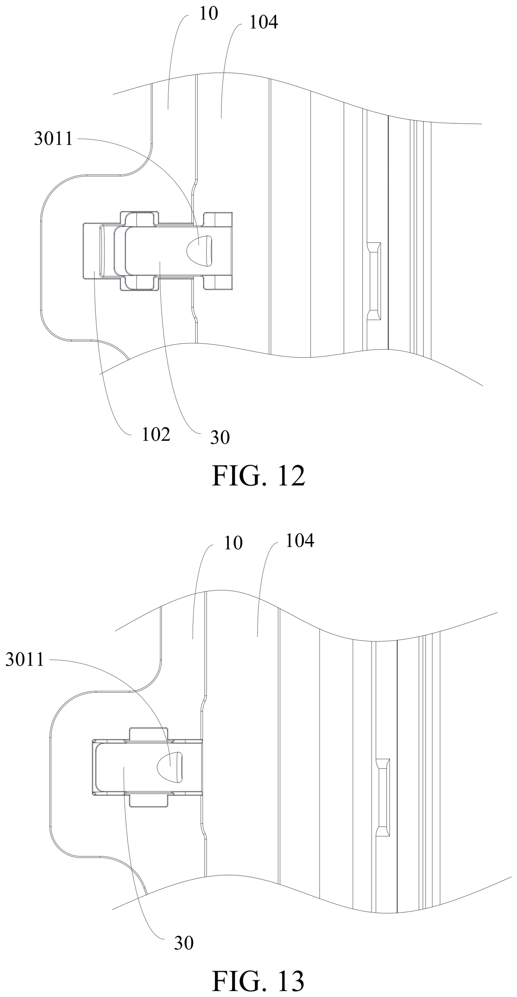

It should be understood that, when no external force is applied, because an elastic force of the elastic member 202 pushes the limiting member 203 and the button cap 201 to move on a side away from the elastic member 202, the limiting member 203 is in an initial position (as shown in FIG. 12). When the user pushes the button cap 201 to move by applying a force, the button cap 201 pushes the limiting member 203 to move toward the elastic member 202 and compress the elastic member 202. In this case, the limiting member 203 may be in a target push position (as shown in FIG. 13). When the user releases the force applied to the button cap 201, under an elastic restoring force of the elastic member 202, the limiting member 203 is caused to move from the target push position to the initial position (as shown in FIG. 12).

It should be noted that, a position of the limiting member 203 or the button cap 201 is detected, so that a button function can be implemented. For example, a metal conductive structure may be disposed on the limiting member 203 or the button cap 201, and the button function can be implemented by disposing a corresponding detection circuit on the frame body 10 and a main board of the electronic device. Alternatively, a Hall component may be disposed on the limiting member 203 or the button cap 201, a Hall detection element is disposed on the frame body 10, and a corresponding detection circuit is disposed on the main board of the electronic device, and is electrically connected to the Hall detection element, to detect position information of the Hall component, thereby implementing the button function. For implementation of a specific button function, refer to the related art, and no further limitation is imposed herein.

Optionally, a button formed by the foregoing button assembly may be referred to as a power button for turning on/off the device, a mute button for one-click mute, or a volume button for adjusting volume.

Optionally, in some embodiments, the rotating member 204 is a sphere.

Because the sphere is used as a contact part between the elastic member 202, the limiting member 203, and the button cap 201, flexibility of rotating can be improved, and stability of movement of the limiting member 203 can be ensured.

Optionally, in some embodiments, the sphere is made of a polyformaldehyde (polyformaldehyde, POM) material.

In this embodiment of this application, the rotating member 204 made of the POM material may be referred to as a steel ball. Because a moving sphere is made of the POM material, and in comparison with the steel ball made of the stainless steel material, in this embodiment of this application, a problem that the button is stuck due to wearing of a position at which the button cap 201 abuts against the rotating member 204 may be avoided.

Optionally, in some embodiments, an avoidance groove 20311 adapted to the rotating member 204 is provided on an inner wall of the limiting through groove 401, and the avoidance groove 20311 is configured to provide avoidance space when the rotating member 204 is mounted.

In this embodiment of this application, the avoidance grooves may be provided on two opposite inner walls of the limiting through groove 401, and the avoidance grooves on the opposite inner walls are provided opposite to each other. Avoidance space formed between two avoidance grooves is slightly less than, equal to, or slightly greater than a volume of the rotating member 204, to facilitate fixing of the rotating member 204 in the limiting through groove 401. Therefore, in this embodiment of this application, the avoidance groove is provided, thereby reducing difficulty in mounting the rotating member 204.

Optionally, in some embodiments, the limiting through groove 401 is provided, toward a side of the mounting groove 101, as a horn-shaped opening, and a part of the rotating member 204 is located in the horn-shaped opening.

In this embodiment of this application, a degree of inclination of the horn-shaped opening may match the rotating member 204, so that the rotating member 204 is well fixed in the horn-shaped opening, and the rotating member 204 is prevented from moving in a Z-axis direction.

Optionally, in some embodiments, a first through hole 2013 is provided on a part of the button cap 201 that is located in the limiting through groove 401, and a second through hole 2032 is provided at a position of the limiting member 203 that is corresponding to the first through hole 2013; and
the button assembly further includes a pin 205 through which the first through hole 2013 and the second through hole 2032 are inserted, to fix the limiting member 203 and the button cap 201.

In this embodiment of this application, the pin 205 may be inserted into the first through hole 2013 and the second through hole 2032 to implement fixing of the limiting member 203 and the button cap 201, and the pin 205 may be removed to implement disassembling of the limiting member 203 and the button cap 201, thereby facilitating mounting and disassembling. Certainly, in other embodiments, the limiting member 203 may alternatively be fixed to the button cap 201 in a manner like threading or snapping.

Optionally, in some embodiments, the electronic device includes a first housing portion and a second housing portion, the first housing portion has a folded state and an unfolded state relative to the second housing portion, and the button assembly is disposed on at least one of the first housing portion and the second housing portion.

In this embodiment of this application, the foregoing electronic device may be understood as a foldable-screen electronic device. The first housing portion may be understood as a housing portion corresponding to a main-screen device, and the second housing portion may be understood as a housing portion corresponding to a sub-screen device.

In the descriptions of this specification, the descriptions of the reference terms such as "an embodiment", "some embodiments", "exemplary embodiments", "example", "specific example", or "some examples" mean that the specific features, structures, materials or characteristics described with reference to the embodiment or example are included in at least one embodiment or example of the present invention. In this specification, schematic descriptions of the foregoing terms do not necessarily refer to a same embodiment or example. Moreover, the specific features, structures, materials, or characteristics described may be combined in any one or more embodiments or examples in an appropriate manner.

Although the embodiments of the present invention have been shown and described, a person of ordinary skill in the art should understand that various changes, modifications, replacements, and variations may be made to the embodiments without departing from the principles and spirit of the present invention, and the scope of the present invention is as defined by the appended claims and their equivalents.

## Claims

1. An electronic device, comprising a frame body and a button assembly, wherein
the frame body comprises a first side surface and a second side surface, the second side surface is exposed to an outer surface of the electronic device, a mounting groove is provided in the frame body, a first opening is provided on the first side surface, a second opening is provided on the second side surface, and both the first opening and the second opening are in communication with the mounting groove;
the button assembly comprises a button cap and an elastic member, the button cap is disposed in the second opening, the elastic member is disposed in the mounting groove, a slide cover is disposed in the first opening, and the slide cover is detachably connected to the frame body; and
a projection size of the elastic member on the first side surface is smaller than a size of the first opening, and a projection size of the elastic member on the second side surface is larger than a size of the second opening.

2. The electronic device according to claim 1, wherein the slide cover comprises a slide cover body and at least two slide bumps disposed on the slide cover body, the slide cover body and the slide bumps are located in the first opening, and the slide bumps are movable between a first position and a second position; and
when the slide bumps are located at the first position, the slide bumps abut against an inner wall of the first opening; and when the slide bumps are located at the second position, the slide bumps are removable from the first opening.

3. The electronic device according to claim 2, wherein two of the slide bumps are disposed at an interval on a first side of the slide cover body, two of the slide bumps are disposed at an interval on a second side of the slide cover body, a first recessed portion adapted to one of the slide bumps on the first side of the slide cover body and a second recessed portion adapted to one of the slide bumps on the second side of the slide cover body are disposed in the first opening, a first protrusion portion is formed between the first recessed portion and a third opening provided on the first side surface, and the two slide bumps of the first side of the first protrusion portion are adaptive; and a second protrusion portion is formed between the second recessed portion and the third opening, and the second protrusion portion is adapted to the two slide bumps of the second side.

4. The electronic device according to claim 2, wherein a pressing plate is disposed on a surface of the slide cover body that faces the mounting groove, and an arc-shaped concave surface adapted to the elastic member is formed on a surface of the pressing plate that faces the mounting groove.

5. The electronic device according to claim 2, wherein a third recessed portion is disposed on a side of the slide cover body that is away from the mounting groove.

6. The electronic device according to claim 1, wherein the elastic member is a spring, a width of the second opening in a first direction is less than an outer diameter of the spring, the first direction is a direction from the first side surface to a third side surface of the frame body, and the first side surface and the third side surface are disposed opposite to each other.

7. The electronic device according to claim 1, wherein a third opening is further provided on the first side surface, the third opening is separately in communication with the first opening and the mounting groove, and the button assembly further comprises a limiting member and a rotating member;
the limiting member is disposed in the third opening, the limiting member is detachably and fixedly connected to the button cap, and the limiting member is provided with a limiting through groove configured to communicate with the mounting groove and the second opening; and
the rotating member is disposed between the elastic member and the limiting member.

8. The electronic device according to claim 7, wherein the rotating member is a sphere.

9. The electronic device according to claim 8, wherein the sphere is made of a polyformaldehyde POM material.

10. The electronic device according to claim 7, wherein an avoidance groove adapted to the rotating member is provided on an inner wall of the limiting through groove, and the avoidance groove is configured to provide avoidance space when the rotating member is mounted.

11. The electronic device according to claim 7, wherein the limiting through groove is provided, toward a side of the mounting groove, as a horn-shaped opening, and a part of the rotating member is located in the horn-shaped opening.

12. The electronic device according to claim 7, wherein a first through hole is provided on a part of the button cap that is located in the limiting through groove, and a second through hole is provided at a position of the limiting member that is corresponding to the first through hole; and
the button assembly further comprises a pin through which the first through hole and the second through hole are inserted, to fix the limiting member and the button cap.

13. The electronic device according to any one of claims 1 to 12, wherein the electronic device comprises a first housing portion and a second housing portion, the first housing portion has a folded state and an unfolded state relative to the second housing portion, and the button assembly is disposed on at least one of the first housing portion and the second housing portion.
